## Europäisches Patentamt

(19) **European Patent Office**

**Office européen des brevets**

(11) Publication number: **0 029 061**

**B1**

(12) EUROPEAN PATENT SPECIFICATION

(45) Date of publication of patent specification: **03.10.84**

(51) Int. Cl.³: **G 03 C 5/00, B 44 C 1/22, C 03 C 15/00, C 23 F 1/00**

(21) Application number: **80901137.2**

(22) Date of filing: **19.05.80**

(86) International application number:
**PCT/US80/00580**

(87) International publication number:
**WO 80/02752 11.12.80 Gazette 80/28**

(54) ACCELERATED PARTICLE LITHOGRAPHIC PROCESSING.

(30) Priority: **31.05.79 US 44073**

(43) Date of publication of application:
**27.05.81 Bulletin 81/21**

(45) Publication of the grant of the patent:
**03.10.84 Bulletin 84/40**

(84) Designated Contracting States:
**DE FR GB NL SE**

(56) References cited:
**US-A-3 143 423
US-A-3 529 960
US-A-3 770 433
US-A-4 056 395
US-A-4 061 799
US-A-4 133 907**

(73) Proprietor: **Western Electric Company, Incorporated
222 Broadway
New York, NY 10038 (US)**

(72) Inventor: **HALL, Thomas Maxwell
14 Flintlock Drive
Warren, NJ 07060 (US)**
Inventor: **WAGNER, Alfred
14 Campbell Lane
Berkeley Heights, NJ 07922 (US)**

(74) Representative: **Weser, Wolfgang et al
Radeckestrasse 43
D-8000 München 60 (DE)**

Courier Press, Leamington Spa, England.

## Description

### Background of the Invention
#### A. Technical Field

The invention refers to a process for fabricating an article of the type as defined in the preamble clause of claim 1.

Small circuits or circuit elements of feature size of the order of a few micrometers or smaller generally undergo one or more lithographic delineation steps in fabrication. One such category of circuits often fabricated in and on an epitaxial silicon is known as large scale integration (LSI). Prevalent manufacture is based on sets of discrete masks patterned by means of ultraviolet light, electron beam or other actinic radiation. An alternative approach, known as "direct processing" is based on primary pattern delineation in masking layers affixed directly to the device or circuit during manufacture.

All such processes involve primary or secondary pattern delineation to eventually permit plating, etching or other modification of underlying active material exclusively in bared regions of apertured masking layers.

Silicon integrated circuitry (SIC) is exemplary of the accelerating development of miniaturized devices. MOS (metal oxide semiconductor) LSI's (large scale integration) are illustrative. State of the art circuitry is represented typically by a chip of dimensions of a small fraction of an inch (of few millimeters) — perhaps 1/4 inch (6.4 mm) square — containing as many as 64,000 individual cells each, in turn, containing a number of individual elements. Design rules — smallest line/space dimensions are now about 3-1/2 micrometers. Such devices are typically fabricated by use of sets of masks with patterns defined in terms of apertured regions in thin chromium layers supported by glass substrates. Mask sets, of perhaps five to fifteen individual masks, serve as primary patterns. Such masks serve to replicate patterns by use of transmitted near UV radiation made incident on suitable actinic material on the device undergoing processing.

Primary pattern generation has gone through a number of stages with sophisticated devices at this time being generated by software control of a monitored travelling beam — generally, an electron beam. Electron sensitive resist material may be negative acting (selectively retained where irradiated) or positive acting. Development of exposed resist is generally wet. The developed pattern is replicated in underlying chromium to result in a so-called "hard" copy mask which is supported on optically polished glass with the entirety serving as the final primary mask.

State of the art replication is showing a trend toward projection printing with replication often 1:1 on the supported photoresist. Once processed, the photoresist then serves to localize any of the various modifications required in fabrication of the device. Examples of such modification include electroplating, ion implantation, etching, etc.

The etching fabrication step is perhaps the most ubiquitous step in fabrication and, consequently, has represented the largest concentration of developmental effort. Wet etching, generally isotropic by nature, served well and continues to serve where feature dimensions do not approach the usually fractional micrometer layer to be processed. Finer features require directionality, i.e., anisotropic etching, generally with minimal undercutting of resist material. Other considerations, e.g., contamination, ease of removal of spent etchant, etc., give rise to a desire for dry etching, or, more generally, for dry processing.

Dry processing may make use of simple vapor chemical reaction but this, in the usual situation, continues to be isotropic. Anisotropic dry processing generally makes use of directionality imposed by net motion of relevant processing species. In the instance of dry etching, use may be made of plasma environment as in simple plasma etching; directionality may be enhanced by use of a dc bias, as in reactive ion etching or sputter etching, or dependence may be had solely on momentum exchange, as in ion milling.

State of the art devices are controllably fabricated by use of mask technology. Registration ability by present means would seem to permit extension of this technology to design rules of about 2 micrometers or perhaps to about 1 micrometer. Registration precision of masks — typically, several inches (e.g. 7.5—15 centimeters) in diameter and containing many tens of circuits — is expected to become limiting so that economic considerations may dictate use of a maskless process for small feature size — perhaps for design rules at about 1 micrometer.

Maskless processing, sometimes known as "direct processing", depends upon primary pattern delineation from software directly on a resist layer intimately supported by the device undergoing processing. Direct processing imposes new requirements both on lithographic apparatus and on resist. Apparatus, in addition to high resolution capability, must, in the usual case, be capable of a throughput much more rapid than that expedient for mask production. Design improvisation depending, for example, on shaped, nonGaussian beams, would appear to be a significant part of the solution. Increased throughput gives rise to a requirement for shortened exposure. Exposure depends upon lithographic sensitivity of the resist and brightness of the source. Considerable effort is being directed toward improvement of both.

Primary pattern delineation implies the need for controllably moving and modulating a focused beam of radiation. Most advanced apparatus depends upon electron beam. Materials of sensitivity adequate for mask making have been developed and are now off-the-shelf items. Electron sources, generally tungsten or thorated tungsten, may soon yield to lower work function thermionic emitter materials, such as, lanthanum hexaboride; or may take the form of high density field emitters. The prevailing view is that one or the other approach coupled with newly emerging resist materials will satisfy lithographic requirements certainly through the expected generations of mask fabrication and likely into direct processing.

There has, for some years, been an ongoing interest in the possibility of delineating beams of larger atomic particles. In general, means for generating, accelerating, focusing, and otherwise controlling charged ions have been adequate for production of micrometer and smaller diameter beams. Development over recent years has been largely directed toward increasing brightness, so that, at this time, means have been described for production of 1 to 1/10 micrometer diameter beams at 1 amp/cm² — representing deposited energy comparable to that of presently used electron beams. Apparatus which has been reported in the literature shows promise of requisite scan rates, focusing, modulation, etc., but it does appear that, for some time, available incident power will continue to be only comparable to electron beam.

It is believed that ion lithography offers potential advantages. A variety of considerations lead to the possibility of improved resolution. A main basis for this expectation is the absence of backscattering of lithographic significance. For the most part, ions are not captured and cannot, therefore, backscatter; while secondary electrons are of significantly lower velocity than the primary electrons used in e-beam lithography. For the most part, it has been assumed that the most promising ion resists would be chosen from among the best electron resists. This continues to be the general consensus and, in fact, the most sensitive e-beam resists are shown to be most sensitive for ion exposure, as well. A problem in ion beam lithography common with that already experienced with electron beam lithography has to do with the need for improved stability, for example, in a variety of processing environments. In e-beam lithography, design to accomplish this end has generally resulted in a loss in sensitivity. So, for example, inclusion of an aryl moiety in the prevalent "COP" (copolymer of glycidyl methacrylate with ethyl acrylate) while increasing processing stability results in the expected decrease in lithographic sensitivity.

US—A—35 29 960 describes a negative-type polymeric photoresist especially tailored for an exposure with ultraviolet light as the patterning radiation, and contains a generalizing hint that also radiation other than UV could be used, such as ion bombardment. Consistent with UV practice sensitizers are added to that photoresist to come to a reasonable sensibility to UV radiation. However, such sensitized photoresists do not have sufficient processing stability as needed for finer design rules.

## Summary of the Invention

### 1. Problem

Ion beam lithography is not now a commercial alternative to electron beam lithography. Equipment, potentially comparable in terms of scan rate, modulation, deposited energy, etc., is under development. Resists generally chosen from among commercially accepted e-beam resists would, together with such apparatus, offer results equivalent to those available from e-beam. Characteristics of the two systems are different, and it does appear that ion beam offers some improvement in resolution largely due to absence of back scattering at least when patterning is carried out in simple single layered resist.

There has been no reason to assume that ion beam offers any solution to the expected problems in e-beam for oncoming generations of lithography. Finer resolution — perhaps direct processing — gives rise to a need for improved chemical and physical stability which, for electron beam, has generally implied some loss in lithographic sensitivity.

### 2. Solution

According to the invention the aforesaid problem is solved with the characterizing features of claim 1.

Thus an unexpected category of negative-acting ion beam resists is made available. The category, exemplified by materials of excellent chemical and physical stability to all usual processing environments, manifests lithographic sensitivity comparable to the best electron beam resists. Availability of this category depends upon the observation that included materials show a nonlinear increasing sensitivity with increasing atomic number (more broadly with deposited energy per particle) than is expected on the basis of traditional calculation. Surprisingly, the category may be defined in terms of lithographic sensitivity below a value considered acceptable for e-beam lithography. The category is defined as consisting of materials which evidence a lithographic sensitivity less than $10^{-5}$ coulombs/cm² as conveniently measured with 20 keV electrons. Lithographic sensitivity means the required minimum dose and energy needed to delineate a pattern in the negative resist, i.e. to result in insolubilization during subsequent development.

Resist materials of the invention typified, for example, by the novolacs (unmodified by any sensitizer) when delineated by oxygen ion beams have a lithographic sensitivity comparable with that of the best electron resists. Stability of novolac to processing environments is well known, since one composition is identical to that which serves as the base polymer in the most prevalent photoresist. A vast category of other materials, generally not considered for lithographic purposes, are members of the category.

Resists of the invention are suitably utilized in the delineation of primary, as well as replicated, images. Aspects of the invention are in terms of delineation in either category. Since processing stability is an important consideration, preferred embodiments are presented in terms of actual device fabrication in which developed images serve to mask underlying regions during a variety of procedures, such as, dry etching.

Detailed Description

The invention is described in terms of:

I. "Introduction"

II. "Resist Composition",

III. "Radiation",

IV. "Postulated Mechanism", and

V. "Examples".

I. Introduction

It will be seen that a complete description of the invention depends on a number of interrelated factors. Many arise from the nature of ion lithography, per se, as distinguished from e-beam lithography. Others derive directly from the postulated mechanism which, in fact, is well supported by extensive experiments. Some design information of a fundamental nature is included for the convenience of the artisan who is not familiar with ion beam lithography. Such information, while possibly useful in setting further operating modes, is not otherwise limiting. So, accordingly, suitable structures for freestanding masks are described; although others may serve satisfactorily.

Belgian Patent No. 877,893, relates to lithography — generally, e-beam lithography — using a category of materials exemplified by modified novolacs. While actinic properties in that BE—A—877 893 are due not to the novolac but to the modifier, certain basic considerations are common. Information concerning, for example, polymer weights, deposition techniques, development, and the like, described in the BE—A 877 893, as well as a number of other considerations, such as those relating to mask and device processing may be useful in practicing this invention.

II. Resist Composition

With the single exception, suitable resists are to be selected in accordance with considerations familiar to those versed in electron beam lithography. Accordingly, the generally organic polymeric materials are generally dissolved in suitable solvents, are deposited on substrates by a variety of techniques — e.g., spinning, spraying, flooding, etc. Parameters are selected with a view to low defect count, good adhesion, and other considerations — e.g., pollution. Resist layer thickness is likely to be a fraction of a micrometer — uniformity in thickness is of the same significance as in e-beam. Substrates, too, are as nearly perfect as feasible so that separate masks for subsequent optical use may be considered on optically polished glass substrates, although masks designed for ion replication may take other forms. Freely supported layers are possible but a presently available approach involves oriented silicon substrates along a major crystallographic axis to permit channeling.

Most noteworthy, from the inventive standpoint, is designation of polymers in terms of maximum permitted sensitivity as measured by use of a 20 keV electron beam. In these terms, materials suitable for the inventive purposes necessarily have a sensitivity less than $10^{-5}$ coulombs/cm$^2$, and, in some instances, preferably at a maximum of $10^{-4}$ coulombs/cm$^2$. Resists of the invention are all negative acting; and so the category prescribed, while representing materials found suitable in accordance with this teaching, at the same time represents materials no better than an order of magnitude less sensitive than the commercially expedient negative-acting electron beam resists. The designated catageory will be of particular significance to the worker who is well aware of the fact that materials of greatest processing stability are so included. Since sensitivity, as so defined, is set at a low value relative to better known e-beam resists, moieties of such prior art resists responsible for cross-linking are necessarily absent. Accordingly, compositions of the invention do not include epoxy groupings or other oxiranes or thiranes or nonresonant unsaturation, in general. Experimental work conducted with polystyrene is generally supportive. Materials with reactive moieties not only do not show enhancement as do members of the category, but actually show a somewhat smaller increase in sensitivity than is predicted on the basis of usual considerations. In fact, a corollary of the inventive teaching shows a loss in sensitivity with increasing energy per particle. Experiments conducted on polybutene sulfon on a copolymer of glycidyl methacrylate and chlorostyrene are supportive of the corollary.

Enhancement in sensitivity with increasing particle size may permit a secondary benefit. It is well known that sensitivity of positive resists decreases with decreasing polymer weight. (Lithographically meaningful cross-linking results only from one cross-linking per molecule.) Paradoxically, use of smaller polymer weight results in reduction in swelling during dissolution particularly where organic solvents are used and so permits increased resolution. Use of larger particles may permit smaller polymer molecules.

## III. Radiation

Most reported work is based on ionized particles, and it is expected that first commercial use of the invention will use helium ions, oxygen ions, or still heavier ions. Experimental work to date suggests improving lithographic sensitivity with increasing atomic number. Alternatives include molecular beams produced by neutralization of ion beams always, however, of atomic numbers 2 or greater. In general, other conditions are secondary. So, for example, where atmospheric constituents do not play an active chemical role in cross-linking, lithographic exposure is carried out with the resist in a vacuum perhaps of $10^{-5}$ mm of Hg, which is desired for formation and maintenance of the beam.

Discussion in this section has been in terms of focused beams which are necessarily used in primary pattern delineation and which may serve in replication, as well. Second replication may, however, take the form of unfocused acceleration in a manner analogous to the *electron imaging projection system* (ELIPS).

Certain minor precautions may be indicated by consideration of underlying material. For example, while doses are small and likely to have very little effect on semiconductor substrates, lightly doped material may suggest use of particles which are not electrically active — e.g., helium, neon.

Energies are desirably such that the resist layer is essentially transparent to the particles. Van de Graaf accelerators easily permit meV particles. Low energy accelerators are usefully employed for producing beams of particles of energies of tens of keV's and higher. .

## IV. Postulated Mechanism

While reliance is not had on a mechanistic explanation, all experiments are supportive of a consistent thesis. Traditionally, low sensitivity negative resists (i.e., low sensitivity e-beam resists) are those with relatively high cross-linking activation energy. It is postulated that such materials require activation at two separate sites to bring about a single cross-linking event. As sensitivity, still measured by electron beam exposure, increases, activation energies are decreased such that a single activation results in a moiety which may, itself, react with a near atom to result in a cross-link. Stated in these terms, low sensitivity negative resists are considered as having two site activation mechanisms, while more sensitive resists are considered as having single site activation mechanisms.

The nature of activation resulting from ion bombardment explains the deviation in sensitivity from the expected relationship. For concerned energies, ion stopping is predominantly electronic with secondary electrons being produced at closely spaced intervals during ion traversal. Such secondary electrons are low energy (relative to the primary electrons used in electron beam lithography). Energies of the order of from a fraction to a few keV result in high absorption cross-section enhancing the likelihood of the required two site activation of sites sufficiently close to permit cross-linking. The effect is that of local electron density far greater than can be accomplished in electron beam lithography with any reasonable flux. Conversely, such concentrated flux in the compact volume about the travelling ion is largely wasted for the single site case. Since secondary electron energy is related to ion velocity, the fundamental requirement for high absorption cross-section (low velocity secondary electrons) can be described in terms of such ion velocity. Dependence on increasing atomic number, true for constant velocity particles, as well as for constant energy particles, comes about from the statistical increase in the number of nonelastic collisions per unit penetration distance — that is, increasing ion energy for given velocity results in greater density of secondary electrons.

## V. Examples

### Example 1
*Preparation of a Novolac*

A 1,000 ml three-neck round bottom flask equipped with a variable speed mechanical stirrer, a water cooled condenser and a thermometer is charged with the following ingredients: 34.0 grams m-cresol; 136.0 grams o-cresol; 30.0 grams p-t butyl phenol; and 126.2 grams of 37 percent aqueous formaldehyde solution. 1.0 gram of oxalic acid is added as a catalyst and the temperature of the mixture is increased to reflux with continuous stirring. After 10 hours, 0.5 grams of additional catalyst is added and thereafter the reaction is allowed to continue for a further period of 10 hours. At this time, the reaction is stopped by removal of the heating means, and the mixture is washed with distilled water. After the aqueous layer is removed by decantation, a condenser is connected to an adapter to permit distillation of the volatile components. A vacuum pump is attached to the reaction vessel, and the novolac is heated slowly under vacuum to minimize foaming. Once the novolac is melted, the stirrer is started and heating is continued until the temperature of the novolac reaches 220 degrees C. It is held at 220 degrees C until the pressure drops to 0.1 mm of mercury, thereby insuring virtually complete removal of the monomers. The vacuum is then released under nitrogen in order to prevent oxidation of the novolac. The molten polymer is then poured into aluminum trays to cool.

The resist solution preparation: Resist solutions are prepared by dissolving 20 grams of the novolac in a solution comprised of 50 percent by volume of methoxy ethyl acetate and 50 percent by volume cyclohexanone. The solutions are then filtered several times through a 0.2 micrometer teflon filter. A silicon wafer is spin coated at 2,000 rpm with the resist solution. The resulting resist thickness is 1.0 micrometer. The resist coated substrate is prebaked at 120 degrees C for two hours. A test pattern is produced by use of a 2 meV Van de Graaf accelerator equipped with electrostatic plates for raster scanning. The beam, approximately 1 mm in diameter, is scanned over approximately 1 mm of a 100 mesh grid which is in contact with the coated substrate. Exposure is carried out with three different ions — hydrogen, helium, and oxygen — altering the deposited energy so as to produce lithographically identical images for each ion. Following exposure, the exposed resist coated substrate is baked at 120 degrees C for fifteen minutes. The development of the exposed film is effected by dipping into a basic aqueous solution of pH 12.6 for three minutes. The patterned resist substrate is then baked at 120 degrees C for one hour.

Whereas conventional calculation suggests lithographic equivalency results from uniform energy deposition without regard to ionic species, actual results are as follows:

| | |
|---|---|
| Hydrogen | 198 eV/nm$^3$ |
| Helium | 80 eV/nm$^3$ |
| Oxygen | 23 eV/nm$^3$. |

### Example 2

Example 1 is repeated, however, substituting polystyrene of weight average molecular weight $M_w$ equals 160,000. Molecular distribution is 2.0; application to produce a 0.8 micrometer thick film on the silicon wafer is by spinning at 2,000 rpm of 9 percent solution in chlorobenzene. Baking to remove excess solvent is at 150 degrees C for one hour. Results for equivalent lithographic imaging (1/2 thickness retention) is as follows:

| | |
|---|---|
| Hydrogen | 8.4 eV/nm$^3$ |
| Helium | 3.2 eV/nm$^3$ |
| Oxygen | 3.5 eV/nm$^3$ |

Note: From a processing standpoint, the small upturn for oxygen relative to helium is of little consequence. From a mechanistic standpoint, the material exemplifies a resist of low threshold cross-linking — even though necessarily two site — which, therefore, shows some "saturation" effect. For the noted conditions, the number of secondary electrons of energy above threshold is vastly greater than for a higher threshold material so that available cross-linking sites are already activated for helium.

## Claims

1. Process for fabrication of an article, especially useful in the fabrication of large-scale integrated circuits, wherein an article surface and an overlying actinic processing layer consisting essentially of a negative-type radiation-sensitive polymeric material, is subjected to an operation including the steps of (1) selectively exposing portions of the said processing layer to patterning actinic radiation to define a pattern whereby ease of removal of the said portions of the processing layer by a developing agent is decreased; (2) treating the said processing layer with said developing agent to selectively remove material outside the said portions to produce a now patterned processing layer and (3) treating the article undergoing fabrication with an altering agent which preferentially alters regions of the said article surface corresponding with selectively removed material in the patterned processing layer, characterized by using the polymeric material which has a lithographic electron beam sensitivity of less than $10^{-5}$ coulomb/cm$^2$ as measured by use of incident 20 keV electrons, and conducting said exposing with actinic radiation, as incident on the said material, consisting predominantly of charged or uncharged species of atomic number at least equal to 2.

2. Process according to claim 1, characterized in that the said polymeric material has a lithographic electron beam sensitivity of less than $10^{-4}$ coulomb/cm$^2$ as defined.

3. Process according to claim 1 or 2, characterized in that the said radiation-sensitive material consists essentially of novolac.

4. Process according to claim 1 or 2, characterized in that the said radiation-sensitive material consists essentially of polystyrene.

5. The process according to any one of preceding claims 1—4, characterized in that the said actinic radiation consists of ions.

6. Process according to any one of preceding claims 1—5, characterized in that the said actinic radiation is focused to form at least one beam which is modulated and scanned relative to the said article undergoing fabrication to define the said pattern.

## Revendications

1. Procédé de fabrication d'un article, particulièrement utile dans la fabrication de circuits intégrés à haut niveau d'intégration, dans lequel une surface d'un article et une couche de traitement actinique recouvrant cette surface, consistant essentiellement en une matière polymère sensible au rayonnement, de type négatif, sont soumis à une opération qui comprend les étapes suivantes: (1) on expose sélectivement des parties de la couche de traitement à un rayonnement actinique de définition de motif pour définir un motif, ce qui a pour effet de diminuer la facilité d'enlèvement desdites parties de la couche de traitement par un agent développateur; (2) on traite la couche de traitement avec l'agent développateur pour enlever sélectivement la manière à l'extérieur desdites parties, de façon à produire une couche de traitement qui porte maintenant un motif et (3) on traite l'article en cours de fabrication avec un agent modificateur qui modifie de façon préférentielle des régions de la surface de l'article correspondant à la matière enlevée sélectivement dans la couche de traitement portant un motif, caractérisé en ce que on utilise une matière polymère qui a une sensibilité lithographique à un faisceau d'électrons inférieure à $10^{-5}$ coulomb/cm², mesurée en utilisant des électrons incidents de 20 keV, et on effectue l'exposition avec un rayonnement actinique, tombant sur la matière, qui consiste de façon prédominante en espèces chargées ou non chargées de numéro atomique au moins égal à 2.

2. Procédé selon la revendication 1, caractérisé en ce que la matière polymére a une sensibilité lithographique à un faisceau d'électrons inférieure à $10^{-4}$ coulomb/cm², avec la définition précédente.

3. Procédé selon la revendication 1 ou 2, caractérisé en ce que la matière sensible au rayonnement consiste essentiellement en novolaque.

4. Procédé selon la revendication 1 ou 2, caractérisé en ce que la matière sensible au rayonnement consiste essentiellement en polystyrène.

5. Procédé selon l'une quelconque des revendications 1—4 précédentes, caractérisé en ce que le rayonnement actinique consiste en ions.

6. Procédé selon l'une quelconque des revendications 1—5 précédentes, caractérisé en ce que le rayonnement actinique est focalisé pour former au moins un faisceau qui est modulé et balayé par rapport à l'article en cours de fabrication, pour définir le motif.

## Patentansprüche

1. Verfahren zur Herstellung eines Gegenstandes, wie dieses insbesondere bei der Herstellung hochintegrierter Schaltungen brauchbar ist, wobei eine Oberfläche des Gegenstandes und eine darüberliegende aktinische Bearbeitungsschicht, die im wesentlichen aus einem negativ arbeitenden strahlungsempfindlichen polymeren Material besteht, einer Behandlung mit folgenden Schritten unterworfen wird

(1) selektives Exponieren von Teilen der Bearbeitungsschicht einer musternden aktinischen Strahlung zur Definition eines Musters, wodurch die Leichtigkeit der Entfernbarkeit der Teile der Bearbeitungsschicht durch ein Entwicklungsmittel verringert wird,

(2) Behandeln der Bearbeitungsschicht mit dem Entwicklungsmittel zur selektiven Entfernung von Material außerhalb der Teile zum Erhalt einer nunmehr gemusterten Bearbeitungsschicht und

(3) Behandeln des der Herstellung unterliegenden Gegenstandes mit einem Änderungsmittel, das Bereiche der Gegenstandsoberfläche mit Vorzug ändert, die dem selektiv entfernten Material in der gemusterten Bearbeitungsschicht entsprechen, gekennzeichnet, durch Verwenden eines polymeren Materials mit einer lithographischen Elektronenstrahlempfindlichkeit von weniger als $10^{-5}$ Coulomb/cm², gemessen bei Verwendung auftreffender 20 keV-Elektronen, und Durchführen der Bestrahlung mit einer aktinischen Strahlung, die bei ihrem Auftreffen auf das Material überwiegend aus geladenen oder ungeladenen Teilchen eines Atomgewichts von wenigstens gleich 2 besteht.

2. Verfahren nach Anspruch 1, dadurch gekennzeichnet, daß das polymere Material eine wie definierte lithographische Elektronenstrahlempfindlichkeit von weniger als $10^4$ Coulomb/cm² besitzt.

3. Verfahren nach Anspruch 1 oder 2, dadurch gekennzeichnet, daß das strahlungsempfindliche Material im wesentlichen aus Novolac besteht.

4. Verfahren nach Anspruch 1 oder 2, dadurch gekennzeichnet, daß das strahlungsempfindliche Material im wesentlichen aus Polystyrol besteht.

5. Verfahren nach einem der Ansprüche 1 bis 4, dadurch gekennzeichnet, daß die aktinische Strahlung aus Ionen besteht.

6. Verfahren nach einem der Ansprüche 1 bis 5, dadurch gekennzeichnet, daß die aktinische Strahlung zur Bildung wenigstens eines Strahlenbündels fokusiert wird, das moduliert und mit dem der der Herstellung unterliegende Gegenstand abgetastet wird, um das Muster zu definieren.